# EUROPEAN PATENT SPECIFICATION

(11) **EP 2 275 258 B1**
(45) Date of publication and mention of the grant of the patent: **26.07.2017**
(21) Application number: 10164266.8
(22) Date of filing: 28.05.2010
(51) Int. Cl.: B41C 1/10, G03F 7/038, G03F 7/033, G03F 7/032, G03F 7/027, G03F 7/09

(54) **Method of preparing lithographic printing plate**
Verfahren zur Herstellung einer Lithographiedruckplatte
Procédé pour la préparation d'une plaque d'impression lithographique

(30) Priority: 29.05.2009 JP 2009131274
(43) Date of publication of application: 19.01.2011
(73) Proprietor: Fujifilm Corporation, Minato-ku Tokyo (JP)
(72) Inventor: Oohashi, Hidekazu, Haibara-gun Shizuoka (JP); Inno, Toshifumi, Shizuoka Shizuoka (JP)
(74) Representative: Hoffmann Eitle

(56) References cited:
- EP-A1- 1 748 317
- JP-A- 2005 271 284

## Description

### FIELD OF THE INVENTION

The present invention relates to a method of preparing a lithographic printing plate. In particular, it relates to a method of preparing a lithographic printing plate using a lithographic printing plate precursor which is excellent in developing property and is prevented from the generation of development scum.

### BACKGROUND OF THE INVENTION

Hitherto, a PS plate having a construction such that a lipophilic photosensitive resin layer (hereinafter also referred to as a photosensitive layer or an image-recording layer) is provided on a hydrophilic support has been broadly used as a lithographic printing plate precursor. As for the plate-making method thereof, the PS plate is ordinarily subjected to mask exposure (open-frame-exposure) through a lith film and then dissolving and removing the non-image area to obtain a desired printing plate. In recent years, digitization techniques of electronically processing, accumulating and outputting image information using a computer have been widespread. As a result, attention has been drawn to a computer-to-plate (CTP) technique wherein a lithographic printing plate precursor is subjected to scanning exposure with highly converging light, for example, laser light according to the digitized image information thereby directly preparing a lithographic printing plate without using a lith film, and as a lithographic printing plate precursor adaptable thereto, a lithographic printing plate precursor having a photopolymerizable photosensitive layer has been developed.

Since a radical reaction in the photopolymerizable photosensitive layer is inhibited by the effect of oxygen in the air, the lithographic printing plate precursor having such a photopolymerizable photosensitive layer ordinarily has a protective layer (oxygen blocking layer) having low oxygen permeability on the photosensitive layer for the purpose of blocking oxygen in the air.

The protective layer of the lithographic printing plate precursor having the photopolymerizable photosensitive layer and the protective layer is ordinarily removed at the time of development or by pre-water washing before the development. In the case of removing the protective layer in any step, however, due to a large coated amount of the protective layer or components constituting the protective layer, the components of the protective layer are concentrated in the developer or water washing solution and the components of the protective layer interact with the components of the photosensitive layer in the developer, whereby deposits may be generated sometimes. The generation of deposit causes problems, for example, of contamination of the developer or water washing solution and of a clog in a pipeline of an automatic development processor.

Further, in the case of processing with a developer of an acidic to weak alkaline range (pH of 2 to 11), since it takes time to remove the protective layer, the developing property of the unexposed area of the photosensitive layer is deteriorated. Moreover, a problem may also occur in that the deposits in the developer adhere on the lithographic printing plate precursor to cause image defect on printed materials.

Polyvinyl alcohol is ordinarily used as a component constituting the oxygen blocking protective layer. However, when polyvinyl alcohol having a high saponification degree is used in order to increase the oxygen blocking property, the generation of deposit (development scum) in the developer becomes pronounced. Although a protective layer containing polyvinyl alcohol and a cation-modified polyvinyl alcohol is described in JP-A-2007-298645 (the term "JP-A" as used herein means an "unexamined published Japanese patent application"), the cation-modified polyvinyl alcohol interacts with a polymer having a carboxylic acid group which is frequently used as a binder of the photosensitive layer to generate the development scum. A protective layer containing a modified polyvinyl alcohol having an acid group or a salt thereof in its molecule is described in JP-A-2006-53316 and JP-A-2006-259137. Although the modified polyvinyl alcohol having an acid group or a salt thereof in its molecule has an effect of preventing the generation of development scum, printing durability may deteriorate sometimes.

The method for preparing a lithographic printing plate described in EP 1 748 317 A1, comprises exposing a lithographic printing plate precursor comprising a hydrophilic support, a photosensitive layer containing amongst others (A) a sensitizing dye having an absorption maximum in a wavelength range of from 350 to 450 nm, (B) a hexaarylbiimidazole compound as a polymerization initiator, (C) a polymerizable compound, and (D) a hydrophobic binder polymer, and a protective layer in this order, with a laser beam of from 350 to 450 nm; and rubbing a surface of the exposed lithographic printing plate precursor with a rubbing member in the presence of a developer having pH of from 2 to 10 in an automatic processor equipped with the rubbing member to remove the protective layer and an unexposed area of the photosensitive layer. In the working examples of the European patent application, coating solutions comprising polyvinyl alcohol having a saponification degree of 98% by mole and a polymerization degree of 500 are used for the protective layer of the lithographic printing plate precursor. In the general description, modified polyvinyl alcohols are mentioned, for instance those having hydrophilic modified sites, such as anionic-modified, cationic-modified, silanol-modified, thiol-modified, alkoxy-modified, sulfide-modified and ester-modified sites.

JP 2005 271284 A aims at providing an original plate for a lithographic printing plate enabling on-press development, which has excellent on-press developing properties, prevents stains on an impression cylinder and emulsification, and exhibits excellent plate wear. In the working examples of the Japanese patent application, lithographic printing plate precursors comprising a protective layer are subjected to on-press development, namely, developing by supplying dampening water and ink on a printing machine. Various protective layers are used in the lithographic printing plate precursors in the working examples of JP 2005 271284 A, including one comprising polyvinyl alcohol modified with (N-isopropyl)acrylamide.

### SUMMARY OF THE INVENTION

Therefore, an object of the present invention is to provide a method of preparing a lithographic printing plate using a lithographic printing plate precursor which is excellent in developing property and is prevented from the generation of development scum.

As a result of the intensive investigations, the inventor has found that the above-described object can be achieved by using in the lithographic printing plate precursor a protective layer containing a nonionic hydrophilic group-modified polyvinyl alcohol, wherein the nonionic hydrophilic group is at least one selected from an alkylene oxide moiety and an amido group.

Specifically, the present invention includes the items, as recited in the appending claims.

According to the present invention, a method of preparing a lithographic printing plate using a lithographic printing plate precursor which is excellent in developing property and is prevented from the generation of development scum, can be provided.

### BRIEF DESCRIPTION OF THE DRAWINGS

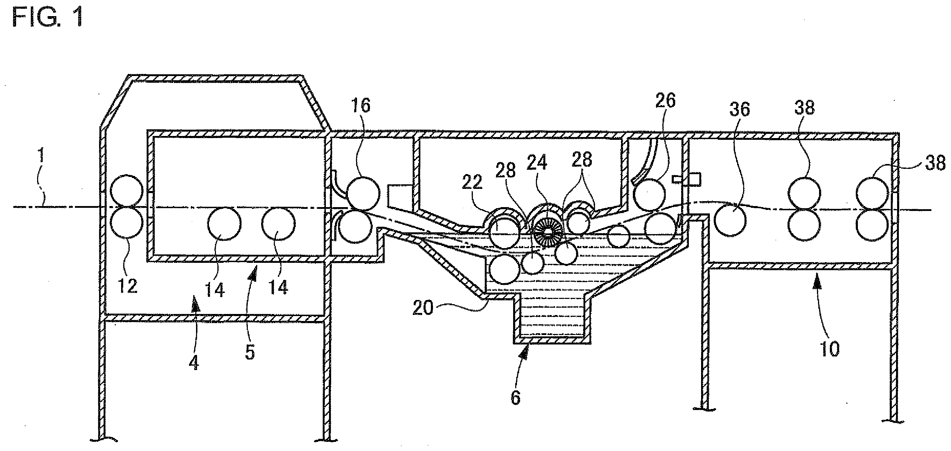

Fig. 1 is a view schematically showing a configuration of an automatic development processor.

### [Description of reference numerals and signs]

- 1:: Lithographic printing plate precursor
- 4:: Pre-heating unit
- 5:: Heating chamber
- 6:: Developing unit
- 10:: Drying unit
- 12:: Carrying-in roller
- 14:: Skewer roller
- 16:: Transport roller
- 20:: Developing tank
- 22:: Transport roller
- 24:: Brush roller
- 26:: Squeeze roller
- 28:: Backup roller
- 36:: Guide roller
- 38:: Skewer roller

### DETAILED DESCRIPTION OF THE INVENTION

### [Lithographic printing plate precursor]

The lithographic printing plate precursor for use in the invention comprises at least a photosensitive layer and a protective layer on a support

### <Protective layer>

The protective layer of the lithographic printing plate precursor for use in the invention is characterized by containing at least one nonionic hydrophilic group-modified polyvinyl alcohol.

The nonionic hydrophilic group-modified polyvinyl alcohol will be described below.

### (Nonionic hydrophilic group-modified polyvinyl alcohol)

The nonionic hydrophilic group-modified polyvinyl alcohol for use in the invention is not particularly restricted as long as it is a vinyl alcohol polymer containing an alkylene oxide moiety or an amido group as a nonionic hydrophilic group in a predetermined amount. It is preferred that the nonionic hydrophilic group-modified polyvinyl alcohol does not have an ionic moiety and is nonionic as a whole.

The nonionic hydrophilic group-modified polyvinyl alcohol for use in the invention preferably includes, for example, a polymer containing (i) a polymerization unit having a nonionic hydrophilic group as specified above and (ii) a vinyl alcohol unit.
A polymer containing (iii) a vinyl acetate unit in addition to (i) a polymerization unit having a nonionic hydrophilic group as specified above and (ii) a vinyl alcohol unit is also preferably used as the nonionic hydrophilic group-modified polyvinyl alcohol.

The unit having a nonionic hydrophilic group which is an alkylene oxide moiety or an amido group is selected, for example, from structures represented by formulae (1) to (6) shown below:

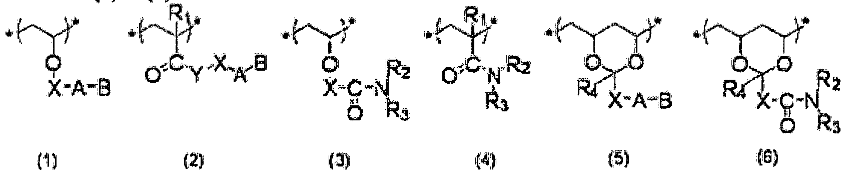

In formulae (1) to (6), X represents a single bond or a divalent connecting group, Y represents -O- or -N(R₃)-. A represents an alkylene oxide moiety, B represents a hydrogen atom or an alkyl group having from 1 to 5 carbon atoms, R₁ represents a hydrogen atom or a methyl group, R₂ to R₄ each represents a hydrogen atom, an alkyl group having from 1 to 5 carbon atoms or -A-B. or R₂ and R₃ may be combined with each other to from a ring, and R₅ represents a hydrogen atom or an alkyl group having from 1 to 5 carbon atoms.

In the above formulae, the divalent connecting group represented by formula X includes a divalent connecting group obtained by combining units represented by formulae shown below.

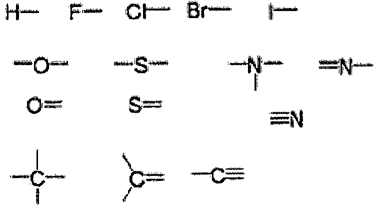

An alkylene group having from 1 to 5 carbon atoms and a carbonylalkylene group having from 2 to 6 carbon atoms are particularly preferred as the divalent connecting group.

Y is preferably -0- or -NH-.

The alkylene oxide moiety represented by A is a moiety having one or more alkylene oxide units each having from 1 to 4 carbon atoms. The alkylene oxide moiety containing plural kinds of alkylene oxide units having different numbers of carbon atoms is preferred and in this case, plural kinds of alkylene oxide units may be arranged as blocks or at random.

The alkylene oxide moiety of block connecting type and alkylene oxide moiety of random connecting type include, for example, those represented by formula (7) and (8) shown below, respectively.

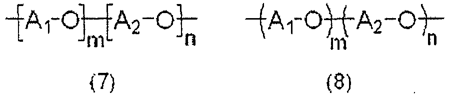

In formulae (7) and (8), A₁ and A₂ each independently represents an alkylene group having from 1 to 4 carbon atoms, and m and n each independently represents a natural number from 0 to 100, provided that both m and n are not 0 at the same time (provided that the case where both m and n are 0 is excluded).

The alkylene oxide moiety of block connecting type represented by formula (7) has a structure wherein a block constituting from m units of A₁-O and a block constituting from n units of A₂-O are connected. The alkylene oxide moiety of random connecting type represented by formula (8) has a structure wherein m units of A₁-O and n units of A₂-O are connected at random. Specific examples of the alkylene oxide moiety of block connecting type and alkylene oxide moiety of random connecting type represented by formulae (7) and (8) wherein A₁ is an ethylene group, A₂ is a propylene group, m is 5 and n is 3 are set forth below. 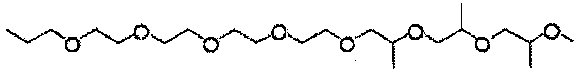 Block connecting type 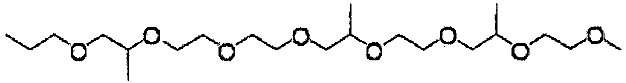 Random connecting type

The nonionic hydrophilic group-modified polyvinyl alcohol may be that appropriately synthesized or a commercially available product.

As a synthesis method of the nonionic hydrophilic group-modified polyvinyl alcohol, a method wherein a monomer having a nonionic hydrophilic group as specified in claim 1 is polymerized with vinyl acetate and then the vinyl acetate units are partially or wholly saponified to form vinyl alcohol units is preferred but the nonionic hydrophilic group-modified polyvinyl alcohol can also be synthesized by connecting a compound having a nonionic hydrophilic group as specified in claim 1 with a hydroxy group of polyvinyl alcohol.

Of the monomers having a nonionic hydrophilic group as specified in claim 1, examples of the monomer having an alkylene oxide group include polyethylene oxide monovinyl ether,
polypropylene oxide monovinyl ether, tetraethyleneoxide monoallyl ether, polyethylene glycol monomethacrylate, polyethylene glycol monoacrylate, polypropylene glycol monomethacrylate, polypropylene glycol monoacrylate, polyethylene glycol
polypropylene glycol monamethacrylate, polyethylene glycol polypropylene glycol monoacrylate, poly(ethylene glycol-tetramethylene glycol)
monomethacrylate, poly(ethylene glycol-tetramethylene glycol) monoacrylate,
poly(ethylene glycol-propylene glycol) monomethacrylate and methoxypolyethylene glycol-polypropylene glycol monoacrylate.

Examples of the monomer having an amido group include acrylamide, methacrylamide, N,N-dimethylacrylamide, N-isopropylacrylamide,
morpholinoacrylamide, N-(aminocarbonylmethyl)acrylamide,
N,N-dihydroxyethylacrylamide and N-vinylformamide.

The compound having a nonionic hydrophilic group which is capable of connecting with a hydroxy group of polyvinyl alcohol includes a compound having both a functional group capable of reacting with a hydroxy group and a nonionic hydrophilic group as specified in claim 1. The functional group capable of reacting with a hydroxy group includes an
aldehyde group, a ketone group, a carboxyl group, a haloalkyl group, a sulfonic acid ester group, an epoxy group and an acryl group. Specific examples of the compound having a nonionic hydrophilic group which is capable of connecting with a hydroxy group of polyvinyl alcohol include compounds shown below. In the compounds shown below, 1 and m each independently represents a natural number from 0 to 100, provided that both 1 and m are not 0 at the same time, and n represents a natural number from 1 to 100.

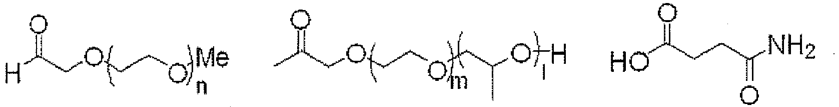

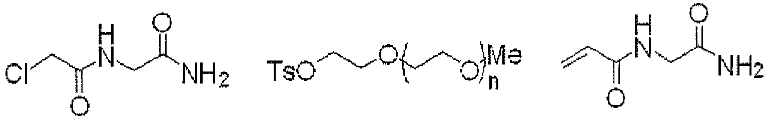

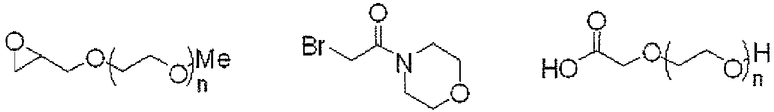

Specific examples of the nonionic hydrophilic group-modified polyvinyl alcohol include compounds shown below.

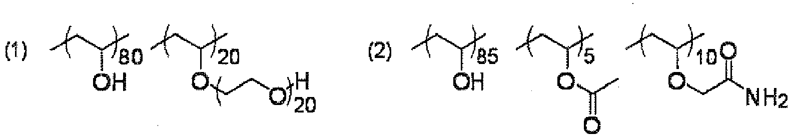

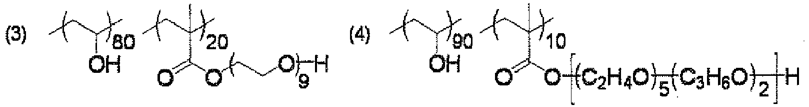

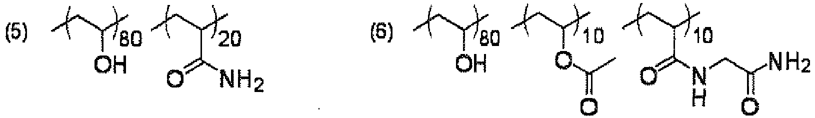

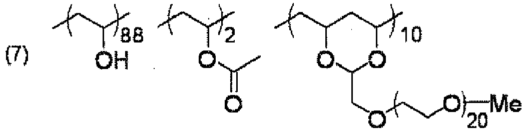

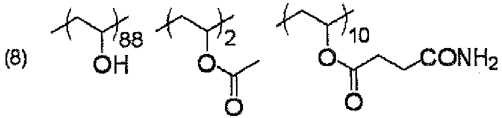

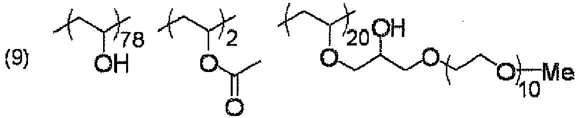

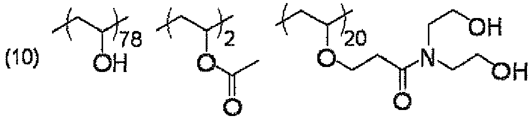

The modification degree of the nonionic hydrophilic group-modified polyvinyl alcohol is preferably from 0.1 to 50% by mole, more preferably from 0.3 to 40% by mole, particularly preferably from 0.5 to 30% by mole, in terms of a mole fraction of a unit having the nonionic hydrophilic group.

The mole fraction of a vinyl alcohol unit in the nonionic hydrophilic group-modified polyvinyl alcohol is preferably from 50 to 98% by mole, more preferably from 60 to 97% by mole, and particularly preferably from 70 to 95% by mole.

The mole fraction of a vinyl acetate unit in the nonionic hydrophilic group-modified polyvinyl alcohol is preferably from 0 to 20% by mole, more preferably from 0 to 10% by mole, and particularly preferably from 0 to 5% by mole.

The nonionic hydrophilic group-modified polyvinyl alcohol has an effect of restraining the deterioration of development removability of the photosensitive layer. In particular, the nonionic hydrophilic group-modified polyvinyl alcohol having a saponification degree of 80% by mole or more is preferred because it exhibits the effect remarkably.

The nonionic hydrophilic group-modified polyvinyl alcohol having such a saponification degree is also commercially available. Specific examples thereof include ECOMATY WO-115 (saponification degree: 92 to 94% by mole), ECOMATY WO-215 (saponification degree: 92 to 94% by mole), ECOMATY WO-315 (saponification degree: 92 to 94% by mole), ECOMATY WO-239 (saponification degree: 98.5 to 99% by mole) and ECOMATY WO-320R (saponification degree: 86.5 to 89.5% by mole) (produced by Nippon Synthetic Chemical Industry Co., Ltd.).

From the standpoint of more effectively restraining the deterioration of development removability of the photosensitive layer, the polymerization degree of the nonionic hydrophilic group-modified polyvinyl alcohol is preferably from 50 to 5,000, more preferably from 100 to 2,500, and particularly preferably from 200 to 1,000.

By using the nonionic hydrophilic group-modified polyvinyl alcohol having the modification degree and polymerization degree described above, a protective layer which can effectively restrain the deterioration of development removability of the photosensitive layer, while maintaining the excellent oxygen blocking property is obtained.

The content of the nonionic hydrophilic group-modified polyvinyl alcohol in the protective layer is ordinarily 50% by weight or more, preferably from 55 to 97% by weight, more preferably from 60 to 95% by weight, based on the total solid content of the protective layer.

The nonionic hydrophilic group-modified polyvinyl alcohols may be used individually or in combination of two or more thereof. When two or more nonionic hydrophilic group-modified polyvinyl alcohols are used, the total content thereof is preferably in the range described above.

### (Inorganic stratiform compound)

The protective layer of the lithographic printing plate precursor for use in the invention may contain an inorganic substratum compound. The inorganic stratiform compound is a particle having a thin tabular shape and includes, for instance, mica, for example, natural mica or synthetic
mica, talc represented by the following formula: 3MgO·4SiO·H₂O, teniolite, montmorillonite, saponite, hectolite and zirconium phosphate.

The inorganic stratiform compound preferably used in the invention is a mica compound. As the mica compound, mica, for example, natural mica represented by the following formula: A (B, C)₂₋₅ D₄ O₁₀ (OH, F, O)₂, (wherein A represents any one of K, Na and Ca, B and C each represents any one of Fe(II), Fe(III), Mn, Al, Mg and V, and D represents Si or Al) or synthetic mica is exemplified.

Of the micas, examples of the natural mica include muscovite, paragonite, phlogopite, biotite and lepidolite. Examples of the synthetic mica include non-swellable mica, for example, fluorphlogopite KMg₃(AlSi₃O₁₀)F₂ or potassium tetrasilic mica KMg_{2.5}(Si₄O₁₀)F₂, and swellable mica, for example, Na tetrasilic mica NaMg_{2.5}(Si₄O₁₀₎F₂, Na or Li teniolite (Na, Li)Mg₂Li(Si₄O₁₀)F₂, or montmorillonite based Na or Li hectolite (Na, Li)_{1/8}Mg_{2/5}Li_{1/8}(Si₄O₁₀)F₂. Synthetic smectite is also useful.

Of the mica compounds, fluorine based swellable mica is particularly useful in the invention. Specifically, the swellable synthetic mica has a stratiform structure composing a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, Na⁺, Ca²⁺ or Mg²⁺, is adsorbed between the lattice layers. The cation existing between the lattice layers is referred to as an exchangeable cation and is exchangeable with various cations. In particular, in the case where the cation between the lattice layers is Li+ or Na⁺, because of a small ionic radius, a bond between the stratiform crystal lattices is week, and the inorganic stratiform compound greatly swells upon contact with water. When share is applied under such a condition, the stratiform crystal lattices are easily cleaved to form a stable sol in water. The swellable synthetic mica has strongly such tendency and is particularly preferably used.

With respect to the shape of the mica compound, the thinner the thickness or the larger the plain size, as long as smoothness of coated surface and transmission of actinic radiation are not damaged, the better from the standpoint of control of diffusion. Therefore, an aspect ratio of the mica compound is ordinarily 20 or more, preferably 100 or more, particularly preferably 200 or more. The aspect ratio is a ratio of major axis to thickness of particle and can be determined, for example, from a projection drawing of particle by a microphotography. The larger the aspect ratio, the greater the effect obtained.

As for the particle size of the mica compound, an average major axis is ordinarily from 0.3 to 20 µm, preferably from 0.5 to 10 µm, particularly preferably from 1 to 5 µm. An average thickness of the particle is ordinarily 0.1 µm or less, preferably 0.05 µm or less, particularly preferably 0.01 µm or less. For example, in the swellable synthetic mica that is the representative compound, the thickness is approximately from 1 to 50 nm and the plain size (major axis) is approximately from 1 to 20 µm.

The content of the mica compound is preferably from 3 to 50% by weight, more preferably from 5 to 40% by weight, based on the total solid content of the protective layer. When the amount is less than 3% by weight, the effect of preventing adhesion between the lithographic printing plate precursors when they are superimposed and the effect of preventing the occurrence of scratch are small. When the amount exceeds 50% by weight, the oxygen permeability becomes excessively small and the lithographic printing plate precursor tends to be fogged by safelight and the film property tends to decrease. When a plural kind of the mica compounds is used together, it is preferred that the total amount of the mica compounds is in the range described above.

The composition (selection of the nonionic hydrophilic group-modified polyvinyl alcohol and mica compound and use of additives) and coating amount of the protective layer are determined in consideration of the antifogging property, adhesion property and scratch resistance in addition to the oxygen-blocking property and development removability.

The protective layer of the lithographic printing plate precursor for use in the invention preferably has oxygen premeability at 25°C under one atmosphere of 0.5 to 100 ml/m² day. In order to achieve the oxygen permeability, it is preferred to use means for adjusting the coating amount.

### (Other components of protective layer)

As to the protective layer, the adhesion property to the photosensitive layer and uniformity of the layer are also extremely important in view of handling of the lithographic printing plate precursor. Specifically, when a hydrophilic layer comprising a water-soluble polymer is laminated on the oleophilic photosensitive layer, layer peeling due to lack of the adhesion property is liable to occur, and the peeled portion causes such a defect as failure in curing of the photosensitive layer due to polymerization inhibition by oxygen. Various proposals have been made for improving the adhesion property between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer.

Any of these known techniques can be applied to the protective layer of the lithographic printing plate precursor for use in the invention as long as the effects of the invention are not damaged. For instance, in the protective layer, the nonionic hydrophilic group-modified polyvinyl alcohol may
be used together with polyvinyl pyrrolidone as the binder component from the standpoint of the adhesion property to the photosensitive layer, sensitivity and prevention of undesirable fog. The weight ratio of the nonionic hydrophilic group-modified polyvinyl alcohol/polyvinyl pyrrolidone is preferably 3/1 or less.

Other than the polyvinyl pyrrolidone, a polymer relatively excellent in crystallizability, for example, cellulose acetate, gelatin, gum arabic, polyacrylic acid or copolymer of acrylic acid or polyvinyl alcohol other than the nonionic hydrophilic group-modified polyvinyl alcohol (for example, polyvinyl alcohol, low saponified polyvinyl alcohol, acid-modified polyvinyl alcohol or cation-modified polyvinyl alcohol) may also be used together with the nonionic hydrophilic group-modified polyvinyl alcohol.

To the protective layer of the lithographic printing plate precursor for use in the invention may be added a coloring
agent (for example, a water-soluble dye), which is excellent in transmission of light used for exposure of the photosensitive layer and capable of efficiently absorbing light having a wavelength which does not concern the exposure. This allows increase in the safe light adaptability without accompanying decrease in the sensitivity.

### (Formation of protective layer)

The protective layer for use in the invention can be formed by preparing, if desired, a dispersion of the mica compound and mixing the dispersion with a binder component including the nonionic hydrophilic group-modified polyvinyl alcohol (or an aqueous solution containing a binder component including the nonionic hydrophilic group-modified polyvinyl alcohol dissolved therein) to prepare a coating solution for protective layer and coating the coating solution on the photosensitive layer.

An example of common dispersing method for the mica compound used in the protective layer is described below. Specifically, from 5 to 10 parts by weight of a swellable mica compound that is preferably exemplified as the mica compound is added to 100 parts by weight of water to adapt the compound to water and to be swollen, followed by dispersing using a dispersing machine. The dispersing machine used includes, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. The dispersion containing from 2 to 15% by weight of the mica compound thus prepared is highly viscous or gelled and exhibits extremely good preservation stability.

In the preparation of a coating solution for protective layer using the dispersion of mica compound, it is preferred that the dispersion is diluted with water, sufficiently stirred and then mixed with the binder component including the nonionic hydrophilic group-modified polyvinyl alcohol (or an aqueous solution containing the binder component including the nonionic hydrophilic group-modified polyvinyl alcohol dissolved therein).

To the coating solution for protective layer can be added known additives, for example, a surfactant for improving coating property or a water-soluble plasticizer for improving physical property of coated layer. Examples of the surfactant include an anionic surfactant, for example, sodium alkylsulfate or sodium alkylsulfonate, an amphoteric surfactant, for example, alkylaminocarboxylate or alkylaminodicarboxylate and a nonionic surfactant, for example, polyoxyethylene alkyl phenyl ether. Examples of the water-soluble plasticizer include propionamide, cyclohexanediol, glycerin and sorbitol. Also, a water-soluble (meth)acrylic polymer may be added. Further, to the coating solution may be added known additives for increasing adhesion property to the photosensitive layer or for improving preservation stability of the coating solution.

A coating method of the protective layer of the lithographic printing plate precursor for use in the invention is not particularly limited, and methods described, for example, in U.S. Patent 3,458,311 and JP-A-55-49729 can be utilized.

The coating amount of the protective layer of the lithographic printing plate precursor for use in the invention is
preferably from 0.3 to 2.0 g/m², more preferably from 0.5 to 1.5 g/m². When the coating amount of the protective layer is less than 0.3 g/m², the film strength of the protective layer can not be maintained and the scratch resistance may tend to deteriorate in some cases. On the other hand, when the coating amount exceeds 2.0 g/m², the removability of the protective layer in the development process may degrade or due to excessive decrease in the oxygen permeability, the safe light aptitude may deteriorate in some cases.

### <Photosensitive layer>

The photosensitive layer of the lithographic printing plate precursor for use in the invention contains at least a sensitizing dye, a polymerization initiator, a polymerizable compound and a binder polymer.

### (Sensitizing dye)

The sensitizing dye can be used without particular limitation as far as it absorbs light at the image exposure to form the excited state and provides energy to a polymerization initiator with electron transfer, energy transfer or heat generation thereby improving the polymerization initiation function. Particularly, a sensitizing dye having an absorption maximum in a wavelength range of 300 to 450 nm or 750 to 1,400 nm is preferably used.

Examples of the sensitizing dye having an absorption maximum in a wavelength range of 300 to 450 nm include merocyanines, benzopyranes, coumarins, aromatic ketones, anthracenes and styryls.

Of the sensitizing dyes having an absorption maximum in a wavelength range of 300 to 450 nm, a dye represented by formula (IX) shown below is more preferable in view of high sensitivity.

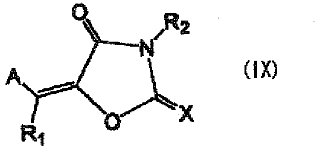

In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

In formula (IX), R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom. Specific examples of the monovalent non-metallic atomic group represented by any one of R₁, R₂ and R₃ include groups described in Paragraph Nos. [0035] to [0043] of JP-A-2007-58170.

A represents an aromatic cyclic group which may have a substituent or a heterocyclic group which may have a substituent. The aromatic cyclic group which may have a substituent or heterocyclic group which may have a substituent are same as the substituted or unsubstituted aryl group and substituted or unsubstituted aromatic heterocyclic residue described for any one of R₁, R₂ and R₃ described above, respectively.

As the sensitizing dye, compounds described in Paragraph Nos. [0047] to [0053] of JP-A-2007-58170 are preferably used.

As another preferable embodiment of the sensitizing dye, a sensitizing dye represented by formula (1) shown below is exemplified.

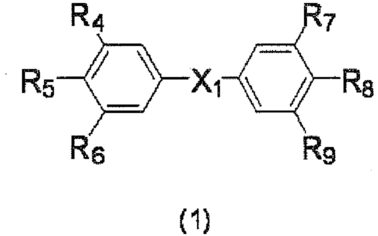

In formula (1), R₄ to R₉ each independently represents a hydrogen atom, an alkyl group, an alkoxy group, a cyano group, a halogen atom, a dialkylamino group, an alkylarylamino group or a diarylamino group, X₁ represents a divalent connecting group selected from the structures shown below which may have a substituent.

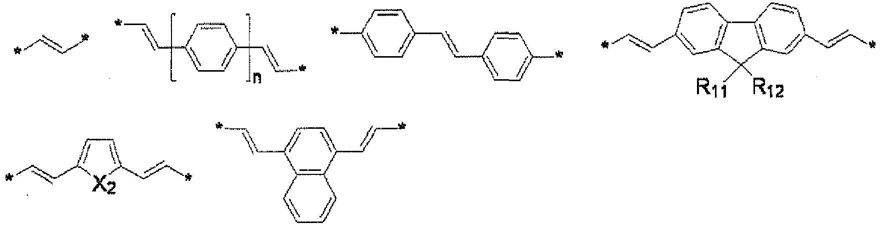

In the structures, n represents an integer of 0 to 2, X₂ represents S, O or NR₁₃, * represents connecting portion connecting to each of the phenyl groups in formula (1), and R₁₁ to R₁₃ each represents an alkyl group.

As such a sensitizing dye, compounds described on pages 10 to 17 and the examples of WO 2008/145530 and on pages 20 to 21 and the examples of WO 2005/111727 are preferably used.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

As the sensitizing dye having an absorption maximum in a wavelength range of 750 to 1,400 (hereinafter, also referred to as an "infrared absorbing agent"), a dye or pigment having an absorption maximum in a wavelength range of 750 to 1,400 is preferably used.

As the dye, commercially available dyes and known dyes described in literatures, for example, Senryo Binran (Dye Handbook) compiled by The Society of Synthetic Organic Chemistry, Japan (1970) can be used. Specifically, the dyes include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

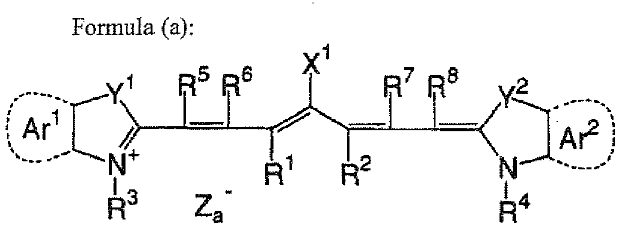

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

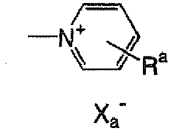

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms. It is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halide ion, a perchlorate ion, a tetrafluorobarate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a) include those described in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments CMC Publishing Co., Ltd. (1986) and Insatsu Ink Gijutsu (Printing Ink Technology), CMC Publishing Co., Ltd. (1984).

The amount of the sensitizing dye added to the photosensitive layer is preferably from 0.05 to 30 parts by weight, more preferably from 0.1 to 20 parts by weight, most preferably from 0.2 to 10 parts by weight, per 100 parts by weight of the total solid content of the photosensitive layer.

### (Polymerization initiator)

As the polymerization initiator (hereinafter, also referred to as an initiator compound), a radical polymerization initiator is preferably used.

As the initiator compound, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferred, and the hexaarylbiimidazole compound is particularly preferred. The polymerization initiators may be appropriately used in combination of two or more thereof.

The hexaarylbiimidazole compound includes, for example, lophine dimers described in JP-B-45-37377 (the term "JP-B" as used herein means an "examined Japanese patent publication") and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2.2'-bis(o-methylphenyl)-4,4',5,5'-tetraphenylbiimidazole and
2,2'-bis(o-trifluoromethylphenyl)-4,4',5,5'-tetraphenylbiimidazole. The hexaarylbiimidazole compound is particularly preferably used together with the sensitizing dye having an absorption maximum in a wavelength range of 300 to 450 nm.

The onium salt preferably used in the invention includes a sulfonium salt, an iodonium salt and a diazonium salt. Particularly, a diaryliodonium salt and a triarylsulfonium salt are preferably used. The opium salt is particularly preferably used together with the infrared absorbing agent having an absorption maximum in a wavelength range of 750 to 1,400 nm.

In addition, polymerization initiators described in Paragraph Nos. [0071] to [0129] of JP-A-2007-206217 are preferably used.

The polymerization initiators are preferably used individually or in combination of two or more thereof. The amount of the polymerization initiator used in the photosensitive layer is preferably from 0.01 to 20% by weight, more preferably from 0.1 to 15% by weight, still more preferably from 1.0 to 10% by weight, based on the total solid content of the photosensitive layer.

### (Polymerizable compound)

The polymerizable compound is an addition-polymerizable compound having at least one ethylenically unsaturated double bond, and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis [p-(3 -methacryloxy-2-hydroxypropoxy)phenyl] dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in J.P-B-58-49860, JP-B-56-17654, JP-B-62-39417 and JP-B-62-39418 are preferably used.

Details of the method of using the polymerizable compound, for example, selection of the structure, individual or combination use or the amount added, can be appropriately determined in accordance with the characteristic design of the final lithographic printing plate precursor. The polymerizable compound is used preferably in a range of 5 to 75% by weight, more preferably in a range of 25 to 70% by weight, particularly preferably in a range of 30 to 60% by weight, based on the total solid content of the photosensitive layer.

### (Binder polymer)

As the binder polymer, a polymer capable of holding the components of photosensitive layer on a support and capable of being removed by a developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer and a polyurethane resin are preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups. The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group of polymer with a compound having the acid group or the like.

One preferable example of the binder polymer for use in the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferable. As the repeating unit having an acid group, a repeating unit derived from (meth)acrylic acid or a repeating unit represented by formula (I) shown below is preferably used.

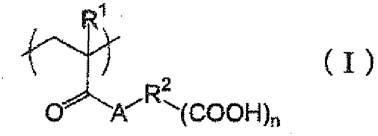

In formula (I), R¹ represents a hydrogen atom or a methyl group, R² represents a single bond or an n+1 valent connecting group, A represents an oxygen atom or -NR³-, wherein R³ represents a hydrogen atom or a monovalent hydrocarbon group having from 1 to 10 carbon atoms, and n represents an integer of 1 to 5.

The connecting group represented by R² in formula (I) is constructed from a carbon atom, a hydrogen atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and most preferably a hydrogen atom or a methyl group. n is preferably from 1 to 3, more preferably 1 or 2, and most preferably 1.

A ratio of the copolymerization component having a carboxyl group in the total copolymerization components of the binder polymer is preferably from 1 to 70% in view of developing property. Considering good compatibility between the developing property and printing durability, it is more preferably from 1 to 50%, and particularly preferably from 1 to 30%.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, and most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer, from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

### (Other components of photosensitive layer)

The photosensitive layer preferably contains a chain transfer agent. As the chain transfer agent, for example, compounds having SH, PH, SiH or GeH in their molecules are used. The chain transfer agent donates hydrogen to a low active radical species to generate a radical or is oxidized and deprotonized to generate a radical. In particular, a thiol compound (for example, a 2-mercaptobenzimidazole, a 2-mercaptobenzthiazole, a 2-mercaptobenzoxazole, a 3-mercaptotriazole or a 5-mercaptotetrazole) is preferably used as the chain transfer agent. Specific examples of the thiol compound include those described in Paragraph Nos. [0212] to [0216] of JP-A-2008-276155.

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity and a plasticizer for increasing plasticity. As the additives, known compounds, for example, compounds described in Paragraph Nos. [0161] to [0215] of JP-A-2007-206217 can be used.

### (Formation of photosensitive layer)

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-znethoxy-2-propanol, 2-methoxyethyl acetate, 1-methoxy-2-propyl acetate and y-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying is preferably from 0.3 to 3.0 g/m². Various methods can be used for the coating. Examples of the coating method include bar coater coating, spin coating, spray coating, curtain coating, dip coating, air knife coating, blade coating and roll coating.

### <Support>

The support of the lithographic printing plate precursor for use in the invention is not particularly restricted as long as it is a dimensionally stable plate-like hydrophilic support. Particularly, an aluminum plate is preferable. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of the support is preferably from 0.10 to 1.2 µm. In the range described above, good adhesion property to the photosensitive layer, good printing durability and good resistance to stain are achieved. The color density of the support is preferably from 0.15 to 0.65 in terms of the reflection density value. In the range described above, good image-forming property by prevention of halation at the image exposure and good aptitude for plate inspection after development are achieved. The thickness of the support is preferably from 0.1 to 0.6 mm, more preferably from 0.15 to 0.4 mm, and still more preferably from 0.2 to 0.3 mm.

### (Hydrophilizing treatment for surface of support and undercoat layer)

As for the lithographic printing plate precursor for use in the invention, in order to increase hydrophilicity of the non-image area and to prevent printing stain, it is preferred to conduct hydrophilizing treatment for the surface of support or to provide an undercoat layer between the support and the photosensitive layer.

The hydrophilizing treatment for the surface of support includes an alkali metal silicate treatment method wherein the support is subjected to an immersion treatment or an electrolytic treatment in an aqueous solution, for example, of sodium silicate, a method of treating with potassium fluorozirconate and a method of treating with polyvinylphosphonic acid. A method of immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. The compound preferably further has a polymerizable group in order to increase the adhesion property to the photosensitive layer. Also, a compound having a hydrophilicity-imparting group, for example, an ethylene oxide group is preferred.

These compounds may be low molecular weight compounds or polymers. For example, a silane coupling agent having an addition-polymerizable ethylenic double bond reactive group described in JP-A-10-282679 and a phosphorus compound having an ethylenic double bond reactive group described in JP-A-2-304441 are preferably exemplified. Low molecular weight compounds or polymer compounds having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 are also preferably used.

A coating amount (solid content) of the undercoat layer is preferably from 0.1 to 100 mg/m², and more preferably from 1 to 30 mg/m².

### <Backcoat layer>

As for the lithographic printing plate precursor for use in the invention, a backcoat layer can be provided on the back surface of the support, if desired. The backcoat layer preferably includes, for example, a coating layer comprising an organic polymer compound described in JP-A-5-45885 and a coating layer comprising a metal oxide obtained by hydrolysis and polycondensation of an organic metal compound or inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### [Method of preparing lithographic printing plate]

The lithographic printing plate precursor for use in the invention is imagewise exposed and subjected to development processing to prepare a lithographic printing plate.

### <Imagewise exposure>

The lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in such a wavelength range is used. In case of exposing with light of 750 to 1,400 nm, the lithographic printing plate precursor containing an infrared absorbing agent which is a sensitizing dye having an absorption maximum in such a wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### <Development processing>

In the present invention, the development processing is a method of developing with a developer having pH of 2 to 11.

According to the method of developing with a developer having pH of 2 to 11, the development and gum solution treatment can be conducted at the same time by incorporating a surfactant or a water-soluble polymer compound into the developer. Therefore, the post-water washing step is not particularly necessary, and after conducting the development and gum solution treatment with one solution, the drying step can be performed. Moreover, since the removal of protective layer can also be conducted simultaneously with the development and gum solution treatment, the pre-water washing step is also not particularly necessary. It is preferred that after the development and gum treatment, the excess developer is removed using a squeeze roller, followed by conducting drying. This developing method is also advantageous in view of being free from the measures against development scum resulting from the protective layer and/or photosensitive layer encountered in case of on-press development, i.e., developing by supplying dampening water and ink on a printing machine.

According to the invention, the method of developing with a developer having pH of 2 to 11 is preferably used. Specifically, in the method of preparing a lithographic printing plate according to the invention, both the protective layer and the unexposed area of the photosensitive layer of the lithographic printing plate precursor are removed with the developer having pH of 2 to 11 so that the resulting lithographic printing plate can be immediately mounted on a printing machine to perform printing. The development of the lithographic printing plate precursor according to the invention is performed in a conventional manner at temperature ordinarily from 0 to 60°C, preferably from about 15 to about 40°C, using, for example, a method wherein the exposed lithographic printing plate precursor is immersed in the developer and rubbed with a brush or a method wherein the developer is splayed to the exposed lithographic printing plate precursor and the exposed lithographic printing plate precursor is rubbed with a brush.

The development processing according to the invention is preferably performed by an automatic development processor equipped with a supplying means for the developer and a rubbing member. An automatic development processor using a rotating brush roll as the rubbing member is particularly preferred. Further, the automatic development processor is preferably provided with a means for removing the excess developer, for example, a squeeze roller or a drying means, for example, a hot air apparatus, subsequently to the development processing means.

The automatic development processor includes, for example, that having a structure as shown in Fig. 1. The automatic development processor shown in Fig. 1 comprises a pre-heating unit 4 for performing heat treatment of the whole surface of a lithographic printing plate precursor 1 before development, a developing unit 6 for developing the lithographic printing plate precursor 1 and a drying unit 10 for drying the lithographic printing plate precursor 1. The exposed lithographic printing plate precursor 1 is carried in through a carrying-in slot into the pre-heating unit 4 by carrying-in rollers 12 and subjected to heat treatment in a heating chamber 5. In the heating chamber 5, a skewer roller 14 is provided. In the heating chamber 5, a heating means (not shown), for example, a heat generating means or a hot air supplying means is also provided. In a developing tank 20 of the developing unit 6, transport rollers 22, a brush roller 24 and squeeze rollers 26 are provided in order from the upstream side in the transporting direction of lithographic printing plate precursor and backup rollers 28 are disposed in appropriate positions therebetween. The lithographic printing plate precursor 1 is immersed in the developer while being transported by the transport rollers 22 and the non-image area of lithographic printing plate precursor 1 is removed by rotation of the brush roller 24 to conduct development processing. The lithographic printing plate precursor 1 subjected to the development processing is transported into the drying unit 10 by the squeeze rollers (carrying-out rollers) 26.

In the drying unit 10, a guide roller 36 and a pair of skewer rollers 38 are disposed in order from the upstream side in the transporting direction. In the drying unit 10, a drying means (not shown), for example, a hot air supply means or a heat generating means is also provided. A discharge slot (not shown) is provided in the drying unit 10 and the lithographic printing plate dried by the drying means is discharged through the discharge slot. A shutter (not shown) is disposed in a passage between the drying unit 10 and the developing unit 6 and when the lithographic printing plate precursor 1 does not pass through the passage, the passage is closed by the shutter.

The developer for use in the invention is preferably an aqueous solution containing water as a main component (containing 60% by weight or more of water). In particular, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is from 2 to 11, preferably from 5 to 10.7, more preferably from 6 to 10.5, and most preferably from 7.5 to 10.3.

The anionic surfactant for use in the developer is not particularly limited and include fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and alkylamine salts, quaternary ammonium salts, polyoxyethylene alkyl amine salts and polyethylene polyamine derivatives are preferably used.

The nonionic surfactant for use in the developer is not particularly limited and include polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferable and alkyl-substituted or unsubstituted phenol ethylene oxide adducts and alkyl-substituted or unsubstituted naphthol ethylene oxide adducts are more preferable.

The amphoteric surfactant for use in the developer is not particularly limited and includes, for example, amine oxide type, for example, alkyldimethylamine oxide, betaine type, for example, alkyl betaine and amino acid type, for example, sodium salt of alkylamino fatty acid. In Particular, alkyldimethylamine oxide which may have a substituent, alkyl carboxy betaine which may have a substituent and alkyl sulfo betaine which may have a substituent are preferably used. Specific examples of the compound are described, for example, in Paragraph Nos. [0255] to [0278] of JP-A-2008-203359 and Paragraph Nos. [0028] to [0052] of JP-A-2008-276166. Specific examples of the more preferable compound include 2-alkyl-N-carboxymethyl-N-hydroxyethyl imidazolinium betaine, alkyldiaminoethylglycine hydrochloride, Iauryldimethylaminoacetic acid betaine, N-lauric acid amidopropyldimethyl betaine and N-lauric acid amidopropyldimethylamine oxide.

Of the surfactants, the amphoteric surfactant and nonionic surfactant are preferred, and the nonionic surfactant is particularly preferred.

Two or more of the surfactants may be used in combination. The content of the surfactant in the developer is preferably from 0.01 to 20% by weight, and more preferably from 0.1 to 10% by weight.

The water-soluble polymer compound for use in the developer includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range of 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

Into the developer, a pH buffer agent may further be incorporated. As the pH buffer agent, a pH buffer agent exhibiting a pH buffer function at pH of 2 to 11 is used without particular restriction. In the invention, a buffer agent for a weak alkaline or neutral range is preferably used and includes, for example, (a) a combination of a carbonate ion and a hydrogen carbonate ion, (b) a borate ion, (c) a combination of a water-soluble amine compound and an ion of the water-soluble amine compound. By the function of the pH buffer agent, fluctuation of the pH of developer is prevented even when the developer is used for a long period of time. As a result, for example, the deterioration of developing property resulting from the fluctuation of pH and the occurrence of development scum are restrained. In particular, the combination (a) of a carbonate ion and a hydrogen carbonate ion or the combination (c) of a water-soluble amine compound and an ion of the water-soluble amine compound is preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof. The total amount of the carbonate ion and hydrogen carbonate ion is preferably from 0.05 to 5 mole/l, more preferably from 0.1 to 2 mole/l, particularly preferably from 0.2 to 1 mole/l, in the developer.

In order for a water-soluble amine compound and an ion of the water-soluble amine compound to be present in the developer, a water-soluble amine compound and an ion obtained by neutralizing the amine compound with an acid may be added to the developer or a water-soluble amine compound and an ion of the water-soluble amine compound may be generated by adding a water-soluble amine compound to the developer and then adjusting the pH. The water-soluble amine compound used is not particularly restricted as long as it is soluble in water. The water-soluble amine compound having a boiling point of 50°C or higher is preferred in order to prevent volatilization when using it. Examples of such an amine compound include triethylamine, dimethylhydroxyethylamine, triethanolamine, morpholine, pyrrolidine, piperidine, 1-methylpiperazine, N-hydroxyethylmorpholine, 1-piperidineethanol and 4-hydroxy-1-methylpiperidine. Examples of the acid for adjusting the pH include hydrochloric acid, hydrobromic acid, perchloric acid, phosphoric acid, sulfuric acid, nitric acid acetic acid, propionic acid, methanesulfonic acid and p-toluenesulfonic acid.

The developer for use in the invention may contain an organic solvent. As the organic solvent, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer can be used as a developer and a development replenisher for the exposed lithographic printing plate precursor and it is preferably applied to the automatic development processor described above. In the case of conducting the development processing using an automatic development processor, the developer becomes fatigued in accordance with the processing amount, and hence the processing ability may be restored using a replenisher or a fresh developer.

In the method of preparing a lithographic printing plate according to the invention, the lithographic printing plate precursor may be heated its entire surface between the exposure and the development, if desired. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions and is ordinarily carried out in a temperature range of 100 to 500°C. When the temperature is too low, a sufficient effect of strengthening the image may not be obtained, whereas when it is excessively high, problems of deterioration of the support and thermal decomposition of the image area may occur sometimes.

### EXAMPLES

The present invention will be described in more detail with reference to the following examples, but the invention should not be construed as being limited thereto.

### Examples 1 to 1 and Comparative Examples 1 to 2

### [Preparation of Lithographic printing plate precursor]

### <Preparation of Support 1>

An aluminum plate (material: JIS A1050, refining: H16) having a thickness of 0.24 mm was immersed in an aqueous 5% by weight sodium hydroxide solution maintained at 65°C to conduct a degreasing treatment for one minute, followed by washing with water. The aluminum plate was immersed in an aqueous 10% by weight hydrochloric acid solution maintained at 25°C for one minute to neutralize, followed by washing with water. Subsequently, the aluminum plate was subjected to an electrolytic surface-roughening treatment with alternating current under condition of current density of 100 A/dm² in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate was subjected to an anodizing treatment under condition of current density of 10 A/dm² and voltage of 15 V in an aqueous 15% by weight sulfuric acid solution at 25°C for one minute and then subjected to a hydrophilization treatment using an aqueous 1% by weight polyvinyl phosphonic acid solution at 75°C to prepare Support 1. The surface roughness of the support was measured and found to be 0.44 µm (Ra indication according to JIS B0601).

### <Formation of Photosensitive layer 1>

Coating solution (1) for photosensitive layer having the composition shown below was coated on Support 1 using a bar and dried in an oven at 90°C for 60 seconds to form Photosensitive layer 1 having a dry coating amount of 1.3 g/m².

### <Coating solution (1) for photosensitive layer>

| | | |
|---|---|---|
| | Binder polymer (1) shown below (weight average molecular weight: 50,000) | 0.04 g |
| Binder polymer (2) shown below (weight average molecular weight: 80,000) | | 0.30 g |
| Polymerizable compound (1) shown below | | 0.17 g |
| | (PLEX6661-O, produced by Degussa Japan) | |
| Polymerizable compound (2) shown below | | 0.51 g |
| Sensitizing dye (1) shown below | | 0.03 g |
| Sensitizing dye (2) shown below | | 0.015 g |
| Sensitizing dye (3) shown below | | 0.015 g |
| Polymerization initiator (1) shown below | | 0.13 g |
| Chain transfer agent | | 0.01 g |
| | Mercaptobenzothiazole | |
| Dispersion of ε-phthalocyanine pigment | | 0.40 g |
| | (pigment: 15 parts by weight; dispersing agent (allyl methacrylate/methacrylic acid copolymer (copolymerization molar ratio: 83/17, weight average molecular weight: 60,000): 10 parts by weight; cyclohexanone: 15 parts by weight) | |
| Thermal polymerization inhibitor | | 0.01 g |
| | N-nitrosophenylhydroxylamine aluminum salt | |
| Fluorine-based surfactant (1) shown below | | 0.001 g |
| 1-Methaxy-2-propanol | | 3.5 g |
| Methyl ethyl ketone | | 8.0 g |

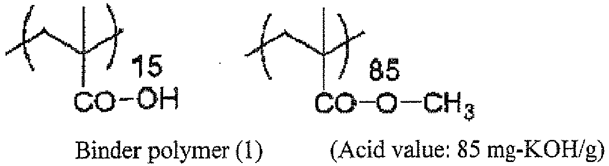

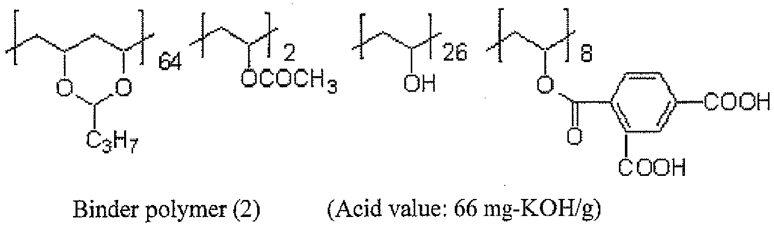

A mixture of the following isomers:

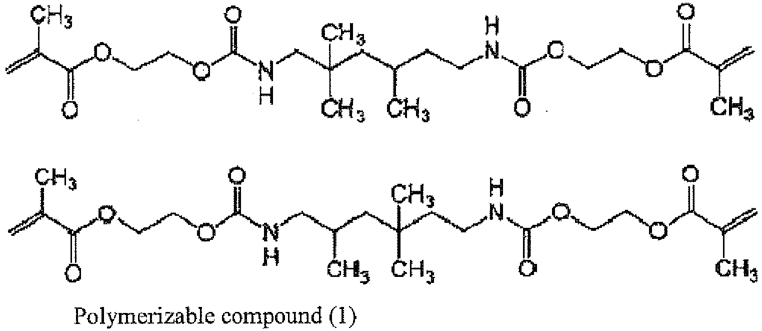

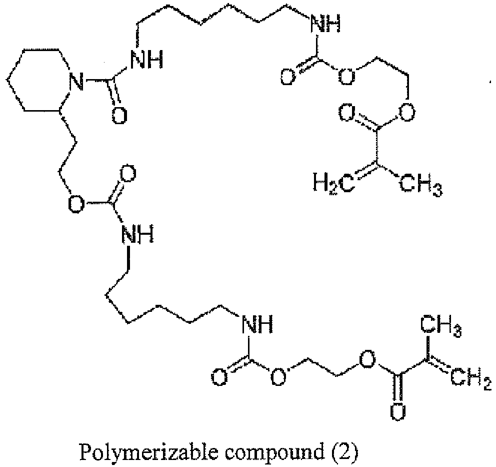

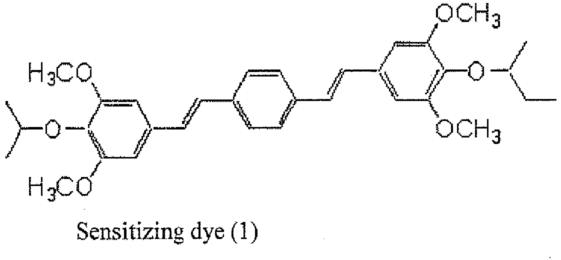

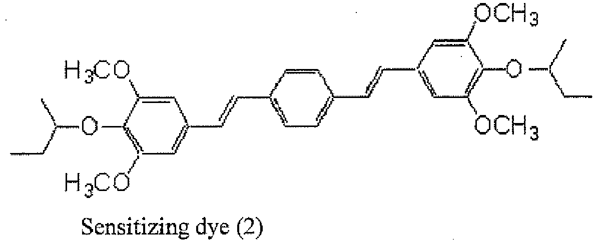

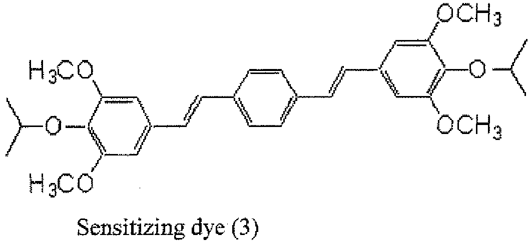

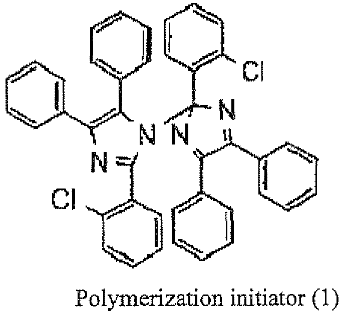

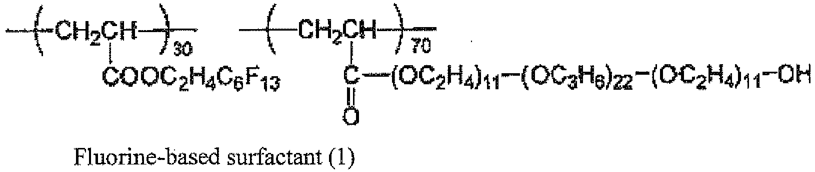

### <Formation of Protective layer 1>

Coating solution (1) for protective layer having the composition shown below was coated on Photosensitive layer 1 using a bar so as to have a dry coating amount of 1.2 g/m² and dried at 125°C for 70 seconds to from Protective layer 1, thereby preparing a lithographic printing plate precursor.

### <Coating solution (1) for protective layer>

| | |
|---|---|
| Polymer for protective layer shown in Table 1 | 0.800 g |
| Vinyl pyrrolidone/vinyl acetate (1/1) copolymer (molecular weight: 70,000) | 0.001 g |
| Surfactant (Emalex 710, produced by Nihon Emulsion Co., Ltd.) | 0.002 g |
| Water | 13 g |

### (1) Exposure, Development and Printing

The lithographic printing plate precursor was subjected to image exposure by a violet semiconductor laser plate setter Vx9600 (having InGaN semiconductor laser: emission: 405 m ± 10 nm/output: 30 mW) produced by FUJIFILM Electronic Imaging, Ltd. As for the image, halftone dots of 50% were drawn using an FM screen (TAFFETA 20, produced by FUJIFILM Corp.) in a plate surface exposure amount of 0.05 mJ/cm² and at resolution of 2,438 dpi.

The exposed lithographic printing plate precursor was subjected to development processing in an automatic development processor having a structure shown in Fig. 1 using Developer 1 having the composition shown below at transporting speed so as to have pre-heating time of 10 seconds at 100°C and immersion time (developing time) in the developer of 20 seconds.

The lithographic printing plate after development was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G(N) black ink (produced by Dainippon Ink and Chemicals, Inc.).

### <Developer 1>

| | |
|---|---|
| Water | 88.6 g |
| Nonionic surfactant (W-1) shown below | 2.4 g |
| Nonionic surfactant (W-2) shown below | 2.4 g |
| Nonionic surfactant (Emalex 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamone | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (Versa TL-77 (30% solution), produced by Alco Chemical) | 1.0 g |

The pH was adjusted to 7.0 with phosphoric acid.

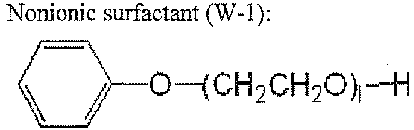

### (Mixture of compounds having 1 of 13 to 28)

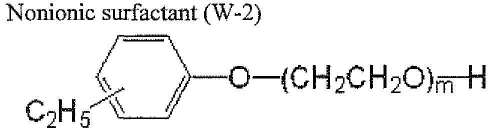

### (Mixture of compounds having m of 12 to 26)

### (2) Evaluation

### <Developing property>

The lithographic printing plate precursor was subjected to the image exposure and development processing as described above while changing the immersion time in the developer. The non-image area of the lithographic printing plate obtained was visually observed and the residue of the photosensitive layer was evaluated according to the following criteria:
A: Good developing property where the photosensitive layer does not remain was obtained at the immersion time of 20 seconds or less.
B: Good developing property where the photosensitive layer does not remain was obtained at the immersion time of more than 20 seconds and 30 seconds or less.
C: Good developing property where the photosensitive layer does not remain was obtained at the immersion time of more than 30 seconds and 40 seconds or less.
D: The photosensitive layer remained even after the immersion for more than 40 seconds to cause development failure.

### <Printing image-forming property>

The lithographic printing plate was subjected to the printing as described above. On the 1,000^{th} printed material, stain resistance in the non-image area and unevenness (unevenness of ink density) of the halftone dot image were evaluated. The stain resistance in the non-image area was evaluated according to the following criteria:
B: Ink stain occurred in the non-image area.
A: Ink stain did not occur in the non-image area.

The unevenness of halftone dot image was evaluated according to the following criteria:
C: The unevenness of ink density occurred in the halftone dot image.
B: Although the slight unevenness of ink density occurred in the halftone dot image, it did not cause problem.
A: The unevenness of ink density did not occur in the halftone dot image and good image was obtained.

### <Processing property>

After the lithographic printing plate precursor was subjected to development processing as described above in an amount of 2,000 m², the generation of scum adhered on the tank wall of the automatic development processor was observed. The evaluation was conducted according to the following criteria:
B: The scum did not generate.
C: The generation of scum was at the acceptable level.
D: The generation of scum was severe.

Further, the case where even after development processing of the lithographic printing plate precursor in an amount of 3,000 m², the scum did not generate was ranked A.

### <Printing durability>

As increase in the number of printed materials, the image of the photosensitive layer formed on the lithographic printing plate was gradually abraded to cause decrease in the ink receptivity, resulting in decrease of ink density of the image on a printing paper. A number of printed materials obtained until the ink density (reflection density) decreased by 0.1 from that at the initiation of printing was determined to evaluate the printing durability.

The results obtained are shown in Table 1. It can be seen from the results shown in Table 1 that the lithographic printing plate precursors containing the nonionic hydrophilic group-modified polyvinyl alcohol in the protective layer thereof according to the invention exhibit the excellent processing property where the generation of development scum is prevented while maintaining the good developing property and printing image-forming property in comparison with the lithographic printing plate precursors for comparative examples containing conventionally used polyvinyl alcohol in the protective layer thereof.

**TABLE 1**

| | Polymer for Protective Layer | Developing Property | Printing Image-Forming Property | | Processing Property | Printing Durability |
|---|---|---|---|---|---|---|
| | | | Stain Resistance in Non-Image Area | Unevenness of Halftone Dot Image | | |
| Example 1 | (1) | B | A | A | B | 100,000 |
| Example 2 | (2) | B | A | A | B | 100,000 |
| Example 3 | (3) | A | A | A | A | 90,000 |
| Example 4 | (4) | A | A | A | A | 100,000 |
| Example 5 | (5) | B | A | A | B | 100,000 |
| Example 6 | (6) | B | A | A | B | 100,000 |
| Example 7 | (7) | A | A | A | A | 90,000 |
| Example 8 | (8) | A | A | A | A | 100,000 |
| Example 9 | (9) | A | A | A | A | 100,000 |
| Example 10 | (10) | A | A | A | A | 100,000 |
| Example 11 | (11) | A | A | A | A | 100,000 |
| Comparative Example 1 | Comparative Polymer 1 | B | A | A | D | 100,000 |
| Comparative Example 2 | Comparative Polymer 2 | A | A | A | A | 80,000 |

The polymers for protective layer used are shown below.

### Polymer for protective layer (1):

ECOMATY WO-115 (polyethylene oxide-modified polyvinyl alcohol, saponification degree: 92 to 94% by mole, produced by Nippon Synthetic Chemical Industry Co., Ltd.)

### Polymer for protective layer (2):

ECOMATY WO-239 (polyethylene oxide-modified polyvinyl alcohol, saponification degree: 98.5 to 99% by mole, produced by Nippon Synthetic Chemical Industry Co., Ltd.)

### Polymer for protective layer (3):

Polymer having the structure represented by (P-1) shown below wherein x/y is 90/10 (in molar ratio) and polymerization degree of 200

### Polymer for protective layer (4):

Polymer having the structure represented by (P-1) shown below wherein x/y is 90/10 (in molar ratio) and polymerization degree of 800

### Polymer for protective layer (5):

Polymer having the structure represented by (P-1) shown below wherein x/y is 90/10 (in molar ratio) and polymerization degree of 1,200

### Polymer for protective layer (6):

Polymer having the structure represented by (P-1) shown below wherein x/y is 95/5 (in molar ratio) and polymerization degree of 800

### Polymer for protective layer (7):

Polymer having the structure represented by (P-1) shown below wherein x/y is 80/20 (in molar ratio) and polymerization degree of 800

### Polymer for protective layer (8):

Polymer having the structure represented by (P-2) shown below and polymerization degree of 800

### Polymer for protective layer (9):

Polymer having the structure represented by (P-3) shown below and polymerization degree of 800

### Polymer for protective layer (10):

Polymer having the structure represented by (P-4) shown below wherein the ethylene oxide unit and the propylene oxide unit are present at random and polymerization degree of 800

### Polymer for protective layer (11):

Polymer having the structure represented by (P-5) shown below wherein the ethylene oxide unit and the propylene oxide unit are present as blocks and polymerization degree of 800

### Comparative polymer 1:

Mixture of 82.25 parts by weight of PVA-205 and 17.75 parts by weight of PVA-105

### Comparative polymer 2:

GOSENOL L-3266 (sulfonic acid-modified polyvinyl alcohol, saponification degree: 86.5 to 89% by mole, produced by Nippon Synthetic Chemical Industry Co., Ltd.)

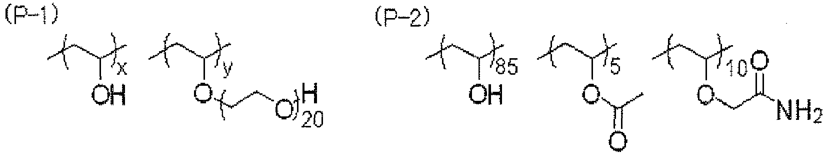

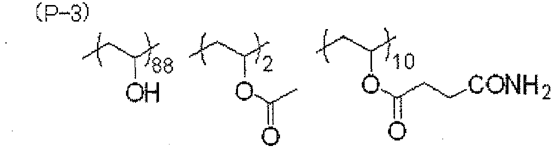

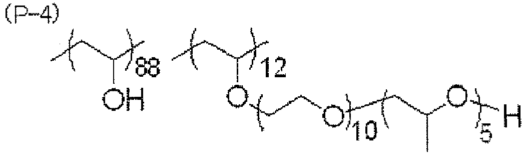

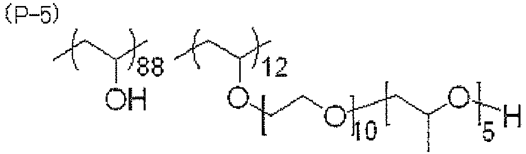

### Examples 12 to 15 and Comparative Example 3

### [Preparation of Lithographic printing plate precursor]

### <Formation of Photosensitive layer 2>

Coating solution (2) for photosensitive layer having the composition shown below was coated on Support 1 using a bar so as to have a dry coating amount of 1.3 g/m² and dried at 75°C for one minute to form Photosensitive layer 2.

### <Coating solution (2) for photosensitive layer>

| | | |
|---|---|---|
| Binder polymer (1) shown above | | 0.45 g |
| Polymerizable compound (1) shown above | | 0.52 g |
| Sensitizing dye (4) shown below | | 0.04 g |
| Polymerization initiator (1) shown above | | 0.08 g |
| Chain transfer agent (1) shown below | | 0.05 g |
| Dispersion of ε-phthalocyanine pigment | | 0.40 g |
| | [pigment: 15 parts by weight; dispersing agent (allyl methacrylate/methacrylic acid copolymer (copolymerization molar ratio: 83/17, weight average molecular weight: 60,000)): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | | 0.006 g |
| | N-nitrosophenylhydroxylamine aluminum salt | |
| Fluorine-based surfactant (1) shown above | | 0.002 g |
| 1-Methoxy-2-propanol | | 8.0 g |
| Methyl ethyl ketone | | 8.0 g |

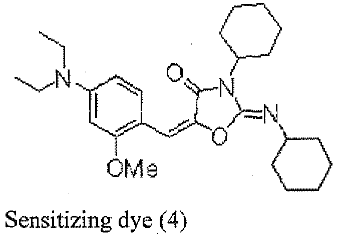

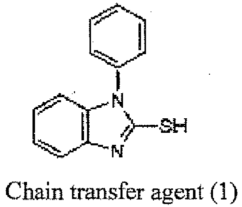

### <Formation of Protective layer 2>

Coating solution (2) for protective layer having the composition shown below was coated on Photosensitive layer 2 using a bar so as to have a dry coating amount of 0.3 g/m² and dried at 75°C for one minute to from Protective layer 2, thereby preparing a lithographic printing plate precursor.

### <Coating solution (2) for protective layer>

| | |
|---|---|
| Dispersion (1) of Mica shown below | 13.00 g |
| Polymer for protective layer shown in Table 2 | 1.30 g |
| Sodium 2-ethylhexylsulfosuccinate | 0.20 g |
| Vinyl pyrrolidone/vinyl acetate (1/1) copolymer (molecular weight: 70,000) | 0.05 g |
| Surfactant (Emalex 710, produced by Nihon Emulsion Co., Ltd.) | 0.05 g |
| Water | 133.00 g |

### (Preparation of Dispersion (1) of Mica)

In 368 g of water was added 32 g of synthetic mica (SOMASIF ME-100, produced by CO-OP Chemical Co., Ltd., aspect ratio: 1,000 or more) and the mixture was dispersed using a homogenizer until the average particle diameter (measured by a laser scattering method) became 0.5 µm to obtain Dispersion (1) of Mica.

With each of the lithographic printing plate precursors, the exposure, development, printing and evaluation were conducted in the same manner as in Example 1 except for changing Developer 1 to Developer 2 shown below. The results obtained are shown in Table 2.

### <Developer 2>

| | |
|---|---|
| Water | 7619.8 g |
| Anhydrous sodium carbonate | 100.0 g |
| Sodium hydrogen carbonate | 50.0 g |
| Amphoteric surfactant (SOFTAZOLINE LPB-R, produced by Kawaken Fine Chemicals Co, Ltd.) | 1500.0 g |
| Amphoteric surfactant (Softazoline LAO, produced by Kawaken Fine Chemicals Co, Ltd.) | 360.0 g |
| Sodium gluconate | 150.0 g |
| TSA 739 (produced by Toshiba Silicones Co., Ltd.) | 20.0 g |
| EDDS (ethylenediaminedisuccinate) | 200.0 g |
| 2-Bromo-2-nitropropane-1,3-diol | 0.1 g |
| 2-Methyl-4-isothiazolin-3 -one | 0.1 g |

The pH was adjusted to 9.8 with phosphoric acid.

**TABLE 2**

| | Polymer for Protective Layer | Developing Property | Printing Image-Forming Property | | Processing Property | Printing Durability |
|---|---|---|---|---|---|---|
| | | | Stain Resistance in Non-Image Area | Unevenness of Halftone Dot Image | | |
| Example 12 | (1) | B | A | A | B | 100,000 |
| Example 13 | (2) | B | A | A | B | 100,000 |
| Example 14 | (4) | A | A | A | A | 100,000 |
| Example 15 | (8) | A | A | A | A | 100,000 |
| Comparative Example 3 | Comparative Polymer 1 | B | A | A | D | 100,000 |

### Examples 16 to 19 and Comparative Example 4

### [Preparation of Lithographic printing plate precursor]

### <Preparation of Support 2>

An aluminum plate (material: JIS A1050) having a thickness of 0.3 mm was subjected to a degrease treatment with an aqueous 10% by weight sodium aluminate solution at 50°C for 30 seconds in order to remove rolling oil on the surface thereof. Thereafter, the aluminum plate surface was grained using three nylon brushes implanted with bundled bristles having a diameter of 0.3 mm and an aqueous suspension (specific gravity: 1.1 g/cm³) of pumice having a median diameter of 25 µm, and then thoroughly washed with water. The aluminum plate was etched by immersing it in an aqueous 25% by weight sodium hydroxide solution at 45°C for 9 seconds and after washing with water, immersed in an aqueous 20% by weight nitric acid solution at 60°C for 20 seconds, followed by washing with water. The etching amount of the grained surface was about 3 g/m².

Subsequently, the aluminum plate was subjected to a continuous electrochemical surface-roughening treatment using alternate current voltage of 60 Hz. The electrolytic solution used was an aqueous 1% by weight nitric acid solution (containing 0.5% by weight of aluminum ion) at a liquid temperature of 50°C. The electrochemical surface-roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was ferrite. The current density was 30 A/dm² in terms of the peak value of current, and 5% of the current flowing from the power source was divided to the auxiliary anode. The quantity of electricity at the nitric acid electrolysis was 175 C/dm² when the aluminum plate was serving as the anode. Then, the aluminum plate was washed with water by spraying.

Then, the aluminum plate was subjected to an electrochemical surface-roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50°C under the conditions that the quantity of electricity was 50 C/dm² when the aluminum plate was serving as the anode, and then washed with water by spraying. The aluminum plate was then treated in an aqueous 15% by weight sulfuric acid solution (containing 0.5% by weight of aluminum ion) as the electrolytic solution at a current density of 15 A/dm² to provide a direct current anodic oxide film of 2.5 g/m², thereafter washed with water and dried to prepare Support 2. The center line average roughness (Ra) of Support 2 was measured using a stylus having a diameter of 2 µm and found to be 0.51 µm.

### <Formation of Undercoat layer 1>

On Support 2 was coated Coating solution (1) for undercoat layer having the composition shown below, followed by drying at 100°C for one minute. The coating amount of Undercoat layer 1 after drying was 10 mg/m².

### <Coating solution (1) for undercoat layer >

| | |
|---|---|
| Polymer Compound (1) shown below (20% by weight NMP solution) | 2.5 g |
| *N*-Methylpyrrolidone | 49.0 g |
| Methanol | 450.0 g |
| Water | 1.5 g |

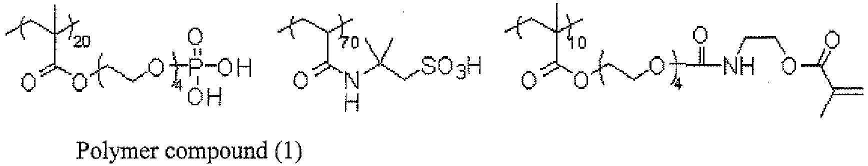

### <Formation of Photosensitive layer 3>

Coating solution (3) for photosensitive layer having the composition shown below was coated on Undercoat layer 1 using a bar so as to have a dry coating amount of 1.3 g/m² and dried at 75°C for one minute to form Photosensitive layer 3.

### <Coating solution (3) for photosensitive layer>

| | | |
|---|---|---|
| | Binder polymer (3) shown below | 0.54 g |
| Polymerizable compound (1) shown above | | 0.48 g |
| Sensitizing dye (4) shown above | | 0.06 g |
| Polymerization initiator (1) shown above | | 0.18 g |
| Chain transfer agent (1) shown above | | 0.07 g |
| Dispersion of ε-phthalocyanine pigment | | 0.40 g |
| | [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | | 0.01 g |
| | N-nitrosophenylhydroxylamine aluminum salt | |
| Fluorine-based surfactant (1) shown above | | 0.001 g |
| Polyoxyethylene-polyoxypropylene condensate | | 0.04 g |
| (Pluronic L44, produced by ADEKA Corp.) | | |
| 1-Methoxy-2-propanol | | 3.5 g |
| Methyl ethyl ketone | | 8.0 g |

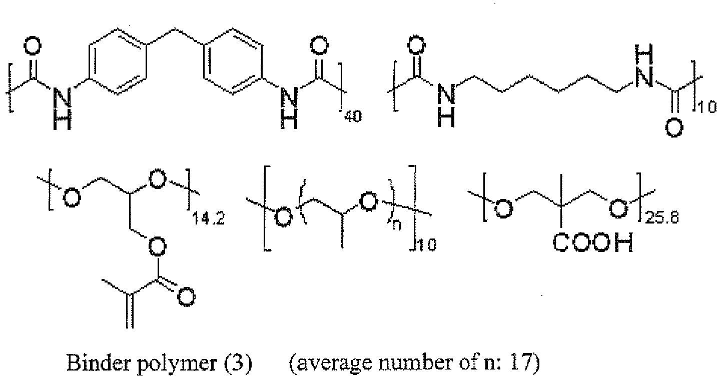

### <Formation of Protective layer 2>

Coating solution (2) for protective layer described above was coated on Photosensitive layer 3 using a bar so as to have a dry coating amount of 0.3 g/m² and dried at 75°C for one minute to from Protective layer 2, thereby preparing a lithographic printing plate precursor.

With each of the lithographic printing plate precursors, the exposure, development, printing and evaluation were conducted in the same manner as in Example 1 except for changing Developer 1 to Developer 3 shown below. The results obtained are shown in Table 3.

### <Developer 3>

| | |
|---|---|
| Water | 7619.8 g |
| Anhydrous sodium carbonate | 100.0 g |
| Sodium hydrogen carbonate | 50.0 g |
| Amphoteric surfactant (PIONIN C-157, produced by Takemoto Oil & Fat Co., Ltd.) | 1860.0 g |
| Sodium gluconate | 150.0 g |
| TSA 739 (produced by Toshiba Silicones Co., Ltd.) | 20.0 g |
| EDDS (Ethylenediaminedisuccianate) | 200.0 g |
| 2-Bromo-2-nitropropane-1,3-diol | 0.1 g |
| 2-Methyl-4-isothiazolin-3-one | 0.1 g |

The pH was adjusted to 9.8 with phosphoric acid.

**TABLE 3**

| | Polymer for Protective Layer | Developing Property | Printing Image-Forming Property | | Processing Property | Printing Durability |
|---|---|---|---|---|---|---|
| | | | Stain Resistance in Non-Image Area | Unevenness of Halftone Dot Image | | |
| Example 16 | (1) | B | A | A | B | 120,000 |
| Example 17 | (2) | B | A | A | B | 120,000 |
| Example 18 | (4) | A | A | A | A | 120,000 |
| Example 19 | (8) | A | A | A | A | 120,000 |
| Comparative Example 4 | Comparative Polymer 1 | B | A | A | D | 120,000 |

### Examples 20 to 21 and Comparative Example 5

### [Preparation of Lithographic printing plate precursor]

### <Formation of Photosensitive layer 4>

Coating solution (4) for photosensitive layer having the composition shown below was coated on Undercoat layer 1 described above using a bar so as to have a dry coating amount of 1.1 g/m² and dried at 70°C for one minute to form Photosensitive layer 4.

Coating solution (4) for photosensitive layer was prepared by mixing Photosensitive solution (1) shown below with Microcapsule solution (1) shown below just before the coating, followed by stirring.

### <Photosensitive solution (1)>

| | |
|---|---|
| Binder polymer (4) shown below | 0.162 g |
| Polymerization initiator (2) shown below | 0.160 g |
| Polymerization initiator (3) shown below | 0.180 g |
| Infrared absorbing agent (1) shown below | 0.020 g |
| Polymerizable compound (ARONIX M-215, produced by Toagosei Co., Ltd.) | 0.3 85 g |
| Fluorine-based surfactant (1) shown above | 0.044 g |
| Methyl ethyl ketone | 1.091 g |
| 1-Methoxy-2-propanol | 8.210 g |

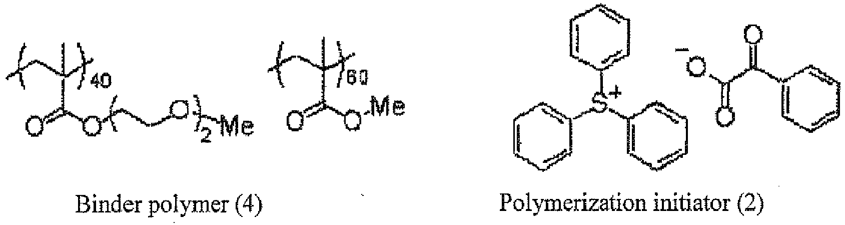

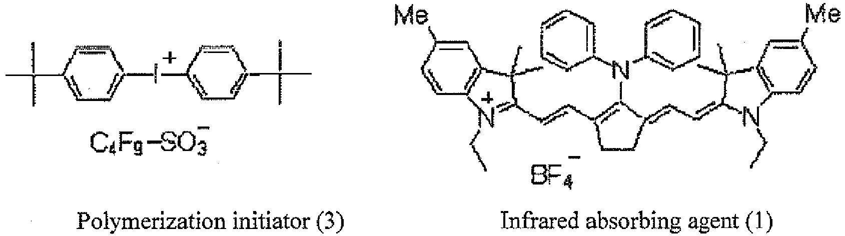

### <Microcapsule solution (1)>

| | |
|---|---|
| Microcapsule (1) shown below | 2.640 g |
| Water | 2.425 g |

### <Preparation of Microcapsule (1)>

An oil phase component was prepared by dissolving 10 g of adduct of trimethylol propane and xylene diisocyanate (TAKENATE D-110N (75% by weight ethyl acetate solution), produced by Mitsui Takeda Chemical Co., Ltd.), 6.00 g of ARONIX SR-399 (produced by Toagosei Co., Ltd.) and 0.1 g of PIONIN A-41C (produced by Takemoto Oil & Fat Co., Ltd.) in 16.67 g of ethyl acetate. As an aqueous phase component, 37.5 g of a 4% by weight aqueous solution of PVA-205 was prepared. The oil phase component and the aqueous phase component were mixed and the mixture was emulsified using a homogenizer at 12,000 rpm for 10 minutes. The resulting emulsion was added to 25 g of distilled water and stirred at room temperature for 30 minutes and then at 40°C for 2 hours. The microcapsule liquid thus-obtained was diluted using distilled water so as to have the solid concentration of 15% by weight to prepare Microcapsule (1). The average particle size of the microcapsule was 0.2 µm.

Coating solution (3) for protective layer having the composition shown below was coated on Photosensitive layer 4 using a bar and dried in an oven at 125°C for 75 seconds to form a protective layer having a dry coating amount of 0.15 g /m², thereby preparing a lithographic printing plate precursor.

### <Coating solution (3) for protective layer>

| | |
|---|---|
| Polymer for protective layer shown in Table 4 (aqueous 6% | 0.134 g |
| by weight solution) | |
| Polyvinyl pyrrolidone (K 30) | 0.0053 g |
| Surfactant (aqueous 1% by weight solution) (EMALEX 710, produced by Nihon Emulsion Co., Ltd.) | 2.15 g |
| Scale-like synthetic mica (aqueous 3.4% by weight dispersion)(MEB 3L, produced by UNICOOCo., Ltd., average particle size: 1 to 5 µm) | 3.75 g |
| Distilled water | 10.60g |

### (1) Exposure and Development

Each of the lithographic printing plate precursors was exposed by Trendsetter 3244VX, produced by Creo Co., equipped with a water-cooled 40 W infrared semiconductor laser under the conditions of output of 9W, a rotational number of an external drum of 210 rpm and resolution of 2,400 dpi. Then, the development processing was performed using Developer 4 having the composition shown below in the same manner as in Example 1 to prepare a lithographic printing plate.

### <Developer 4>

| | |
|---|---|
| Water | 100.00 g |
| Polyoxyethylene naphthyl ether (average number of oxyethylene: n = 13) | 0.50 g |
| Sodium salt of dioctylsulfosuccinic acid ester | 0.50 g |
| Ammonium primary phosphate | 0.05 g |
| Citric acid | 0.05 g |

The pH was adjusted to 7.0 with phosphoric acid and sodium hydroxide.

With the printing plate obtained, the printing and evaluation were conducted in the same manner as in Example 1. The results obtained are shown in Table 4.

**TABLE 4**

| | Polymer for Protective Layer | Developing Property | Printing Image-Forming Property | | Processing Property | Printing Durability |
|---|---|---|---|---|---|---|
| | | | Stain Resistance in Non-Image Area | Unevenness of Halftone Dot Image | | |
| Example 20 | (1) | B | A | A | B | 40,000 |
| Example 21 | (8) | A | A | A | A | 40,000 |
| Comparative Example 5 | Comparative Polymer 1 | B | A | A | D | 40,000 |

It can be seen from the results shown in Tables 2 to 4 that the lithographic printing plate precursors containing the nonionic hydrophilic group-modified polyvinyl alcohol in the protective layer thereof according to the invention exhibit the excellent processing property where the generation of development scum is prevented while maintaining the good developing property and printing image-forming property in comparison with the lithographic printing plate precursors for comparative examples containing conventionally used polyvinyl alcohol in the protective layer thereof, even when the constituting component, for example, a support or a photosensitive layer of the lithographic printing plate precursor or the composition of the developer are changed.

## Claims

1. A method for preparing a lithographic printing plate comprising: processing a lithographic printing plate precursor with a developer having pH of from 2 to 11, wherein the lithographic printing plate precursor comprises, in the following order:
a support;
a photosensitive layer comprising a sensitizing dye, a polymerization initiator, a polymerizable compound and a binder polymer; and
a protective layer comprising a nonionic hydrophilic group-modified polyvinyl alcohol, wherein the nonionic hydrophilic group is at least one selected from an alkylene oxide moiety and an amido group.

2. The method for preparing a lithographic printing plate as claimed in claim 1, wherein the nonionic hydrophilic group-modified polyvinyl alcohol is a polymer comprising (i) a polymerization unit having a nonionic hydrophilic group and (ii) a vinyl alcohol unit.

3. The method for preparing a lithographic printing plate as claimed in claim 2, wherein the polymerization unit having a nonionic hydrophilic group is at least one selected from structures represented by the following formulae (1) to (6): 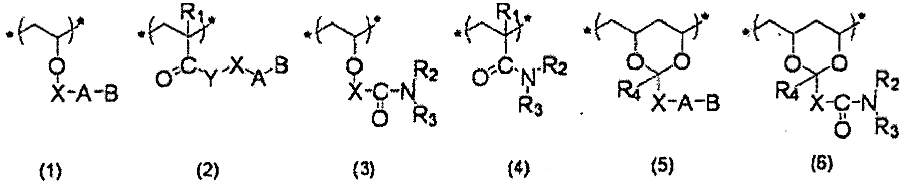 wherein X represents a single bond or a divalent connecting group, Y represents -0- or -N(R₅)-, A represents an alkylene oxide moiety, B represents a hydrogen atom or an alkyl group having from 1 to 5 carbon atoms, R₁ represents a hydrogen atom or a methyl group, R₂ to R₄ each represents a hydrogen atom, an alkyl group having from 1 to 5 carbon atoms or -A-B, or R₂ and R₃ may be combined with each other to from a ring, and R₅ represents a hydrogen atom or an alkyl group having from 1 to 5 carbon atoms.

4. The method for preparing a lithographic printing plate as claimed in claim 3, wherein the alkylene oxide moiety is at least one selected from an alkylene oxide moiety of block connecting type represented by the following formula (7) and an alkylene oxide moiety of random connecting type represented by the following formula (8): 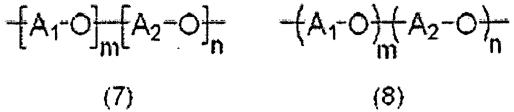 wherein A₁ and A₂ each independently represents an alkylene group having from 1 to 4 carbon atoms, and m and n each independently represents a natural number from 0 to 100, provided that both m and n are not 0 at the same time.

5. The method for preparing a lithographic printing plate as claimed in any one of claims 1 to 4, wherein the developer comprises a carbonate ion and a hydrogen carbonate ion.

6. The method for preparing a lithographic printing plate as claimed in any one of claims 1 to 4, wherein the developer comprises a water-soluble amine compound and an ion of the water-soluble amine compound.

7. The method for preparing a lithographic printing plate as claimed in any one of claims 1 to 4, wherein the developer comprises a nonionic surfactant.

## Patentansprüche

1. Verfahren zur Herstellung einer Lithographiedruckplatte, umfassend:
Verarbeiten eines Lithographiedruckplattenvorläufers mit einem Entwickler mit einem pH-Wert von 2 bis 11, wobei der Lithographiedruckplattenvorläufer in der folgenden Reihenfolge umfasst:
einen Träger;
eine fotoempfindliche Schicht, umfassend einen Sensibilisierungsfarbstoff, einen Polymerisationsinitiator, eine polymerisierbare Verbindung und ein Bindepolymer; und
eine Schutzschicht, umfassend einen mit einer nicht-ionischen hydrophilen Gruppe modifizierten Polyvinylalkohol, worin die nicht-ionische hydrophile Gruppe mindestens eine ist, ausgewählt aus einer Alkylenoxideinheit und einer Amidgruppe.

2. Verfahren zur Herstellung einer Lithographiedruckplatte gemäß Anspruch 1, worin der mit einer nicht-ionischen hydrophilen Gruppe modifizierte Polyvinylalkohol ein Polymer ist, umfassend (i) eine Polymerisationseinheit, die eine nicht-ionische hydrophile Gruppe aufweist, und (ii) eine Vinylalkoholeinheit.

3. Verfahren zur Herstellung einer Lithographiedruckplatte gemäß Anspruch 2, worin die Polymerisationseinheit, die eine nicht-ionische hydrophile Gruppe aufweist, zumindest eine ist, die ausgewählt ist aus den durch die folgenden Formeln (1) bis (6) dargestellten Strukturen: 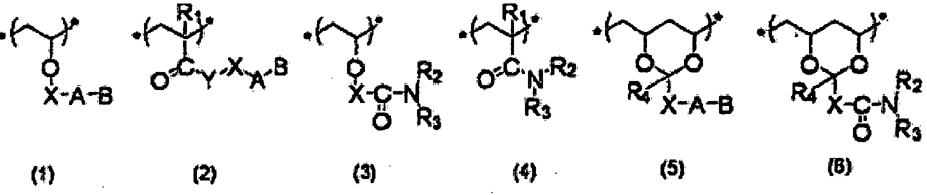 worin X eine Einfachbindung oder eine divalente Verknüpfungsgruppe darstellt, Y -O- oder -N(R₅)-darstellt, A eine Alkylenoxideinheit darstellt, B ein Wasserstoffatom oder eine Alkylgruppe mit 1 bis 5 Kohlenstoffatomen darstellt, R₁ ein Wasserstoffatom oder eine Methylgruppe darstellt, R₂ bis R₄ jeweils ein Wasserstoffatom, eine Alkylgruppe mit 1 bis 5 Kohlenstoffatomen oder -A-B darstellen, oder R₂ und R₃ miteinander verbunden sein können, um einen Ring zu bilden, und R₅ ein Wasserstoffatom oder eine Alkylgruppe mit 1 bis 5 Kohlenstoffatomen darstellt.

4. Verfahren zur Herstellung einer Lithographiedruckplatte gemäß Anspruch 3, worin die Alkylenoxideinheit mindestens eine ist, ausgewählt aus einer Alkylenoxideinheit vom Block-Verbindungstyp, dargestellt durch die folgende Formel (7), und einer Alkylenoxideinheit vom statistischen Verknüpfungstyp, dargestellt durch die folgende Formel (8): 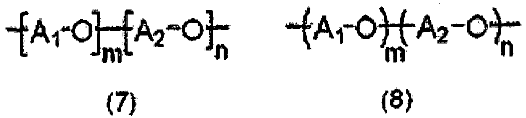 worin A₁ und A₂ jeweils unabhängig eine Alkylengruppe mit 1 bis 4 Kohlenstoffatomen darstellen und m und n jeweils unabhängig eine natürliche Zahl von 0 bis 100 darstellen, mit der Maßgabe, dass m und n nicht gleichzeitig 0 sind.

5. Verfahren zur Herstellung einer Lithographiedruckplatte gemäß irgendeinem der Ansprüche 1 bis 4, worin der Entwickler ein Carbonation und ein Hydrogencarbonation umfasst.

6. Verfahren zur Herstellung einer Lithographiedruckplatte gemäß irgendeinem der Ansprüche 1 bis 4, worin der Entwickler eine wasserlösliche Aminverbindung und ein Ion der wasserlöslichen Aminverbindung umfasst.

7. Verfahren zur Herstellung einer Lithographiedruckplatte gemäß irgendeinem der Ansprüche 1 bis 4, worin der Entwickler ein nicht-ionisches Tensid umfasst.

## Revendications

1. Procédé pour préparer une plaque d'impression lithographique comprenant : le traitement d'un précurseur de plaque d'impression lithographique avec un révélateur ayant un pH de 2 à 11, dans lequel le précurseur de plaque d'impression lithographique comprend, dans l'ordre suivant:
un support ;
une couche photosensible comprenant un colorant sensibilisant, un initiateur de polymérisation, un composé pouvant être polymérisé et un polymère liant ; et
une couche protectrice comprenant un alcool polyvinylique modifié par un groupe hydrophile non ionique, dans lequel le groupe hydrophile non ionique est au moins un groupe sélectionné parmi une fraction d'oxyde d'alkylène et un groupe amido.

2. Procédé pour préparer une plaque d'impression lithographique selon la revendication 1, dans lequel l'alcool polyvinylique modifié par un groupe hydrophile non ionique est un polymère comprenant (i) une unité de polymérisation ayant un groupe hydrophile non ionique et (ii) une unité d'alcool vinylique.

3. Procédé pour préparer une plaque d'impression lithographique selon la revendication 2, dans lequel l'unité de polymérisation ayant un groupe hydrophile non ionique est au moins une unité sélectionnée parmi des structures représentées par les formules suivantes (1) à (6) : 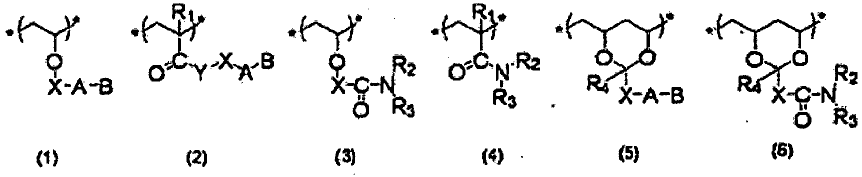 dans lesquelles X représente une liaison simple ou un groupe de connexion divalent, Y représente -O- ou -N(R₅)-, A représente une fraction d'oxyde d'alkylène, B représente un atome d'hydrogène ou un groupe alkyle ayant de 1 à 5 atomes de carbone, R₁ représente un atome d'hydrogène ou un groupe méthyle, R₂ à R₄ représentent chacun un atome d'hydrogène, un groupe alkyle ayant de 1 à 5 atomes de carbone ou -A-B, ou R₂ et R₃ peuvent être combinés l'un avec l'autre pour former un cycle, et R₅ représente un atome d'hydrogène ou un groupe alkyle ayant de 1 à 5 atomes de carbone.

4. Procédé pour préparer une plaque d'impression lithographique selon la revendication 3, dans lequel la fraction d'oxyde d'alkylène est au moins une fraction sélectionnée parmi une fraction d'oxyde d'alkylène de type à connexion de bloc représentée par la formule suivante (7) et une fraction d'oxyde d'alkylène de type à connexion aléatoire représentée par la formule suivante (8) : 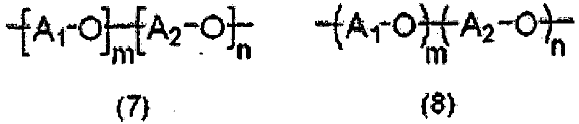 dans lesquelles A₁ et A₂ représentent chacun indépendamment un groupe alkylène ayant de 1 à 4 atomes de carbone, et m et n représentent chacun indépendamment un nombre naturel de 0 à 100, à condition que tant m que n ne soient pas à 0 en même temps.

5. Procédé pour préparer une plaque d'impression lithographique selon l'une quelconque des revendications 1 à 4, dans lequel le révélateur comprend un ion de carbonate et un ion de carbonate d'hydrogène.

6. Procédé pour préparer une plaque d'impression lithographique selon l'une quelconque des revendications 1 à 4, dans lequel le révélateur comprend un composé d'amine hydrosoluble et un ion du composé d'amine hydrosoluble.

7. Procédé pour préparer une plaque d'impression lithographique selon l'une quelconque des revendications 1 à 4, dans lequel le révélateur comprend un surfactant non ionique.
